(19) Europäisches Patentamt
European Patent Office
Office européen des brevets

(11) **EP 4 284 587 B1**

(12) **EUROPÄISCHE PATENTSCHRIFT**

(45) Veröffentlichungstag und Bekanntmachung des Hinweises auf die Patenterteilung:
**30.10.2024 Patentblatt 2024/44**

(21) Anmeldenummer: **21848250.3**

(22) Anmeldetag: **20.12.2021**

(51) Internationale Patentklassifikation (IPC):
**B23K 20/10** (2006.01)   **B23K 101/36** (2006.01)

(52) Gemeinsame Patentklassifikation (CPC):
**B23K 20/10;** B23K 2101/38; H01L 2224/4847;
H01L 2224/78; H01L 2224/85205

(86) Internationale Anmeldenummer:
**PCT/DE2021/101019**

(87) Internationale Veröffentlichungsnummer:
**WO 2022/161567 (04.08.2022 Gazette 2022/31)**

(54) **VERFAHREN ZUM BETREIBEN EINER ULTRASCHALLVERBINDUNGSVORRICHTUNG**

METHOD FOR OPERATING AN ULTRASONIC CONNECTING DEVICE

PROCÉDÉ DE FONCTIONNEMENT D'UN DISPOSITIF DE CONNEXION À ULTRASONS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.01.2021 DE 102021101654**

(43) Veröffentlichungstag der Anmeldung:
**06.12.2023 Patentblatt 2023/49**

(73) Patentinhaber: Hesse GmbH
**33104 Paderborn (DE)**

(72) Erfinder:
• **JOCHHEIM, Andreas**
**33100 Paderborn (DE)**

• **HUNSTIG, Matthias**
**33104 Paderborn (DE)**
• **BRÖKELMANN, Michael**
**33129 Delbrück (DE)**

(74) Vertreter: **Wickord, Wiro**
**Wickord Buser Patentanwälte PartG mbB**
**Rathenaustraße 96**
**33102 Paderborn (DE)**

(56) Entgegenhaltungen:
WO-A1-2008/140541    DE-A1- 102019 118 249
US-A- 4 571 688    US-A- 4 597 519

**Beschreibung**

Die Erfindung betrifft ein Betriebsverfahren für eine Ultraschallverbindungsvorrichtung sowie die Verwendung des Verfahrens bei der elektrischen Kontaktierung von Komponenten der Leistungselektronik.

Bekannte Verfahren zum Verbinden elektrisch leitender Bauteile mittels Ultraschalls sehen vielfach vor, dass die zu verbindenden Bauteile aneinander angelegt und gegeneinander angedrückt werden. Wenigstens ein Bauteil wird dann mittels eines Ultraschallwerkzeugs zu Schwingungen im Ultraschallbereich angeregt mit der Folge, dass sich eine stoffschlüssige Verbindung zwischen den Bauteilen ausbildet. Die Qualität und Güte der elektrischen Verbindung, welche auf diese Weise hergestellt wird, werden dabei maßgeblich durch die Schwingungsparameter, insbesondere die Frequenz und die Schwingungsamplitude, sowie die Prozesskraft bestimmt, mit der die Bauteile beim Herstellen der Verbindung gegeneinander angedrückt werden.

Exemplarisch zeigt die DE 10 2019 118 249 A1 ein Betriebsverfahren für eine Ultraschallverbindungsvorrichtung, bei der zwei spaltfrei aneinanderliegende Verbindungsbauteile miteinander verbunden werden, sowie eine Ultraschallverbindungsvorrichtung zur Durchführung des Verfahrens. Weitere derartige Verfahren offenbaren die US 4,597,519 A und die US 4,571,688 A.

Je nach Beschaffenheit und Konfiguration der Bauteile sowie der zur Herstellung der elektrisch leitenden Verbindung der Bauteile vorgesehenen Verbindungsanordnung kann es sein, dass die zu verbindenden Bauteile zunächst nicht unmittelbar aneinander anliegen beziehungsweise Kontakt haben. Sofern beispielsweise ein Anschlussleiter, insbesondere ein mit einem vergleichsweise dicken Querschnitt ausgebildeter Laststromanschlussleiter, mit einer Leistungselektronik-Baugruppe verbunden werden muss, wird der Anschlussleiter zunächst oberhalb eines Verbindungsbereichs der Leistungselektronik-Baugruppe positioniert. Aufgrund von Fertigungstoleranzen bildet sich dabei zwischen dem Anschlussleiter und dem Verbindungsbereich typischerweise ein Spalt unbekannter Größe. Erst beim Absenken des Ultraschallwerkzeugs wird der Anschlussleiter durch das Ultraschallwerkzeug gegen eine Anschlussoberfläche des Verbindungsbereichs angedrückt und dabei elastisch verformt. Ein Teil einer über das Ultraschallwerkzeug aufgeprägten Bondkraft ist demzufolge notwendig, um noch vor dem Herstellen der stoffschlüssigen Verbindung den Anschlussleiter zu verformen.

Um zu gewährleisten, dass die Ultraschallverbindung zuverlässig, innerhalb kurzer Zeit und mit gleichbleibend hoher Qualität hergestellt wird, ist eine genaue Kenntnis und Überwachung der Prozessparameter wichtig. Um beispielsweise die Prozesszeit, in der der Ultraschall wirkt, ermitteln zu können, muss bekannt sein, wann der Spalt zwischen dem Anschlussleiter und dem Verbindungsbereich geschlossen ist und die beiden Bauteile einander berühren. Darüber hinaus ermöglicht es die Kenntnis des zeitlichen Verlaufs der zwischen den Bauteilen wirkenden Prozesskraft, Einfluss auf den Verbindungsprozess zu nehmen und diesen so zu überwachen, dass aus den Prozessparametern auf die Qualität beziehungsweise Güte der Ultraschallverbindung geschlossen werden kann.

Aufgabe der vorliegenden Erfindung ist es demzufolge, ein verbessertes Betriebsverfahren für eine Ultraschallverbindungsvorrichtung anzugeben.

Zur Lösung der Aufgabe weist die Erfindung die Merkmale des Patentanspruchs 1 auf. Demzufolge umfasst ein Verfahren zum Betrieb einer Ultraschallverbindungsvorrichtung, welche einen in eine z-Richtung verfahrbaren Ultraschallkopf mit einem Träger, einer relativ beweglich zu dem Träger an ebendiesem gehaltenen Ultraschallerzeugungseinrichtung und einem von der Ultraschallerzeugungseinrichtung zur Ultraschallschwingung anregbaren Ultraschallwerkzeug vorsieht, die folgenden Schritte:

- Ein elektrisch leitender Anschlussleiter wird so oberhalb eines an einem Verbindungsbauteil vorgesehenen, elektrisch leitend ausgebildeten Verbindungsbereichs positioniert, dass zwischen dem Anschlussleiter einerseits und einer dem Anschlussleiter zugewandten Anschlussoberfläche des Verbindungsbereichs andererseits ein Spalt mit einem in die z-Richtung bestimmten Spaltmaß gebildet ist,

- der Ultraschallkopf wird relativ zu dem Anschlussleiter und dem Verbindungsbauteil oberhalb des Anschlussleiters so positioniert, dass eine zur Anlage an den Anschlussleiter ausgebildete Kontaktfläche des Ultraschallwerkzeugs dem Anschlussleiter zugewandt ist,

- die Ultraschallerzeugungseinrichtung wird mit einer in die z-Richtung wirkenden Bondkraft beaufschlagt und gegen den Träger angedrückt,

- der Ultraschallkopf wird dann in die z-Richtung abgesenkt, es werden eine Verfahrposition des Ultraschallkopfes in die z-Richtung sowie eine in die z-Richtung bestimmte Relativposition der Ultraschallerzeugungseinrichtung zu dem Träger ermittelt, und aus der Verfahrposition des Ultraschallkopfes und der Relativposition der Ultraschallerzeugungseinrichtung zu dem Träger wird ein Kontaktzeitpunkt ermittelt, an dem der Anschlussleiter durch das Ultraschallwerkzeug so weit abgesenkt worden ist, dass er den Verbindungsbereich des Verbindungsbauteils berührt.

Der besondere Vorteil der Erfindung besteht darin, dass durch die Kenntnis des Kontaktzeitpunkts die Prozessdauer bestimmt werden kann, während der die über die Ultraschallschwingungen in die Verbindungsstelle eingebrachte Energie zur stoffschlüssigen Verbindung des Anschlussleiters und des Verbindungsbauteils beiträgt. Der Verbindungsprozess kann insofern präzise durchgeführt und kontrolliert beziehungsweise überwacht werden mit der Folge, dass die stoffschlüssige Verbindung sicher hergestellt beziehungsweise Verbindungsfehler erkannt werden können. Sicherheitszugaben in Bezug auf die Prozessdauer können vermieden beziehungsweise reduziert werden, so dass letztlich der Durchsatz erhöht und die Wirtschaftlichkeit des Verfahrens verbessert werden.

Nach einer bevorzugten Ausführungsform der Erfindung wird der Kontaktzeitpunkt bestimmt, indem eine Differenz zwischen einer zeitlichen Änderung der Verfahrposition des Ultraschallkopfes und der Relativposition der Ultraschallerzeugungseinrichtung zu dem Träger ermittelt und dann ein Nullwert für die Differenz erkannt wird. Sofern die zeitliche Änderung der Verfahrposition einerseits und der Relativposition andererseits gleich groß sind, entfernt sich die Ultraschallerzeugungseinrichtung mit der gleichen Geschwindigkeit vom Träger, mit der der Ultraschallkopf abgesenkt wird. Dies ist dann der Fall, wenn der Anschlussleiter gegen die Anschlussoberfläche des Verbindungsbereichs angelegt ist und selbst noch keine Verformung erfährt.

Nach einer Weiterbildung der Erfindung wird für den Kontaktzeitpunkt aus der Bondkraft einerseits und einer Stützkraft, mit der die Ultraschallerzeugungseinrichtung gegen den Träger angedrückt wird, beziehungsweise einer Schließkraft, die zum Schließen des Spalts zwischen dem Anschlussleiter und dem Verbindungsbauteil aufgebracht wird, andererseits eine zwischen dem Anschlussleiter und dem Verbindungsbauteil wirkende Prozesskraft bestimmt. Insbesondere wird die Prozesskraft als Differenz der Bondkraft zu der Stützkraft beziehungsweise zu der Schließkraft bestimmt. Vorteilhaft kann der Verbindungsprozess bei Kenntnis der Prozesskraft noch zielgenauer beeinflusst beziehungsweise überwacht werden. Die Aufprägung einer Mindestprozesskraft kann ebenso sichergestellt werden wie die verfahrenstechnische Abbildung eines sich für die spezielle Verbindungsaufgabe als günstig erwiesenen Prozesskraft-Zeitverlaufs. Hier können beispielsweise spezielle Materialparameter für den Anschlussleiter, seine Querschnittsform beziehungsweise sein Durchmesser berücksichtigt werden.

Beispielsweise wird die Stützkraft zwischen der Ultraschallerzeugungseinrichtung und dem Träger sensorisch erfasst. Die Schließkraft kann beispielsweise als die Bondkraft im Kontaktzeitpunkt bestimmt sein.

Das erfindungsgemäße Verfahren wird beispielsweise verwendet, um einen Laststromanschlussleiter mit einer Anschlusskomponente einer Leistungselektronik-Baugruppe zu verbinden. Aufgrund der vergleichsweise hohen Ströme weisen die hierzu verwendeten Anschlussleiter einen vergleichsweise großen Querschnitt auf, so dass klassische Bondverfahren, bei denen der Anschlussleiter über den Ultraschallkopf kontinuierlich zugeführt wird, an ihre Grenzen kommen. Stattdessen wird der Anschlussleiter zugeschnitten beziehungsweise vorgeformt und separat gehandhabt. Er wird dann so in Position gebracht, dass er oberhalb des Verbindungsbereichs vorgesehen ist und sich der Spalt unbekannter Größe zwischen dem Anschlussleiter und dem Verbindungsbereich ausbildet.

Aus den weiteren Unteransprüchen und der nachfolgenden Beschreibung sind weitere Vorteile, Merkmale und Einzelheiten der Erfindung zu entnehmen. Die dort erwähnten Merkmale können jedenfalls einzeln für sich oder auch in beliebiger Kombination im Rahmen der Ansprüche erfindungswesentlich sein. Die Zeichnungen dienen lediglich beispielhaft der Klarstellung der Erfindung und haben keinen einschränkenden Charakter.

Es zeigen:

Fig. 1    eine Prinzipdarstellung eines Ultraschallkopfes einer Ultraschallverbindungsvorrichtung vor dem Herstellen einer Ultraschallverbindung,

Fig. 2    den Ultraschallkopf der Ultraschallverbindungsanordnung nach Fig. 1 beim Herstellen der Ultraschallverbindungsanordnung,

Fig. 3    verschiedene Geschwindigkeits-Zeitverläufe beim Herstellen der Ultraschallverbindung für einen ersten Verbindungsfall,

Fig. 4    verschiedene Kraft-Zeitverläufe für den ersten Verbindungsfall und

Fig. 5    verschiedene Geschwindigkeits-Zeitverläufe beim Herstellen der Verbindungsanordnung für einen zweiten Verbindungsfall.

Eine zur Durchführung des erfindungsgemäßen Verfahrens geeignete Ultraschallverbindungsanordnung umfasst einen Ultraschallkopf 1, der in eine z-Richtung verfahrbar ist. Der Ultraschallkopf 1 sieht einen Träger 2 sowie eine relativ beweglich zu dem Träger 2 an ebendiesem gehaltene Ultraschallerzeugungseinrichtung 3 vor. An der Ultraschallerzeugungseinrichtung 3 ist ein im vorliegenden Fall in die z-Richtung längserstrecktes und sich an einem der Ultraschallerzeugungseinrichtung 3 abgewandten freien Ende keilförmig verjüngendes Ultraschallwerkzeug 4 festgelegt. Die Ultraschallerzeugungseinrichtung 3 umfasst beispielsweise piezokeramische Elemente beziehungsweise Wandler, die infolge elektrischer Eingangssignale das Ultraschallwerkzeug 4 zu mechanischen Schwingungen im Ultraschallbereich anregen.

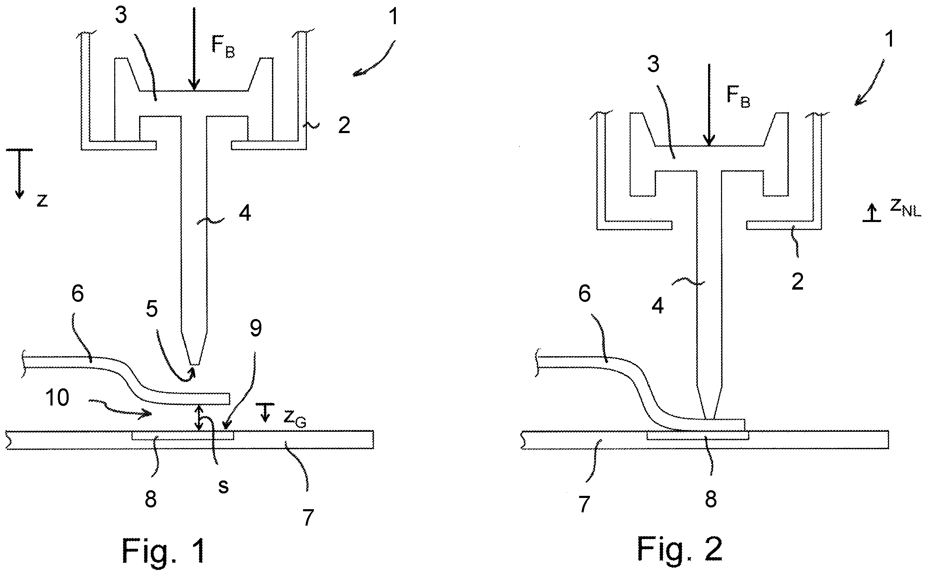

In einer Ausgangskonfiguration gemäß Fig. 1 ist der Ultraschallkopf 1 oberhalb eines an einem Verbindungsbauteil 7 ausgebildeten, elektrisch leitenden Verbindungsbereichs 8 vorgesehen. Zwischen einer dem Verbindungsbereich 8 zugewandten Kontaktfläche 5 des Ultraschallwerkzeugs 4 und dem Verbindungsbereich 8 ist ein Anschlussleiter 6 positioniert. Bei dem Anschlussleiter 6 handelt es sich beispielsweise um einen Laststromanschlussleiter, der mit Hilfe der Ultraschallverbindungsvorrichtung stoffschlüssig mit dem Verbindungsbereich 8 des Verbindungsbauteils 7 verbunden wird. Eine Anschlussoberfläche 9 des Verbindungsbereichs 8 ist dabei dem Anschlussleiter 6 zugewandt.

Der Anschlussleiter 6 ist in der Ausgangskonfiguration beabstandet zu dem Verbindungsbauteil 7 positioniert, so dass zwischen dem Verbindungsbereich 8 des Verbindungsbauteils 7 und dem Anschlussleiter 6 ein Spalt 10 mit einem in die z-Richtung erstreckten Spaltmaß s gebildet ist. Darüber hinaus ist der Anschlussleiter 6 beabstandet zu dem Ultraschallwerkzeug 4 vorgesehen.

Fig. 2 zeigt die Ultraschallverbindungsvorrichtung während der Herstellung der Ultraschallverbindung. Es ist hierbei so, dass nunmehr der Anschlussleiter 6 durch das Ultraschallwerkzeug 4, welches mit der Kontaktfläche 5 an den Anschlussleiter 6 angelegt ist, gegen die Anschlussoberfläche 9 des Verbindungsbereichs 8 angedrückt ist. Das Ultraschallwerkzeug 4 wird von der Ultraschallerzeugungseinrichtung 3 zu Schwingungen angeregt und mit einer in die z-Richtung wirkenden Bondkraft $F_B$ beaufschlagt. Der Ultraschallkopf 1 ist dabei so weit in die z-Richtung verfahren beziehungsweise abgesenkt, dass die Ultraschallerzeugungseinrichtung 3 beabstandet vom Träger 2 vorgesehen ist.

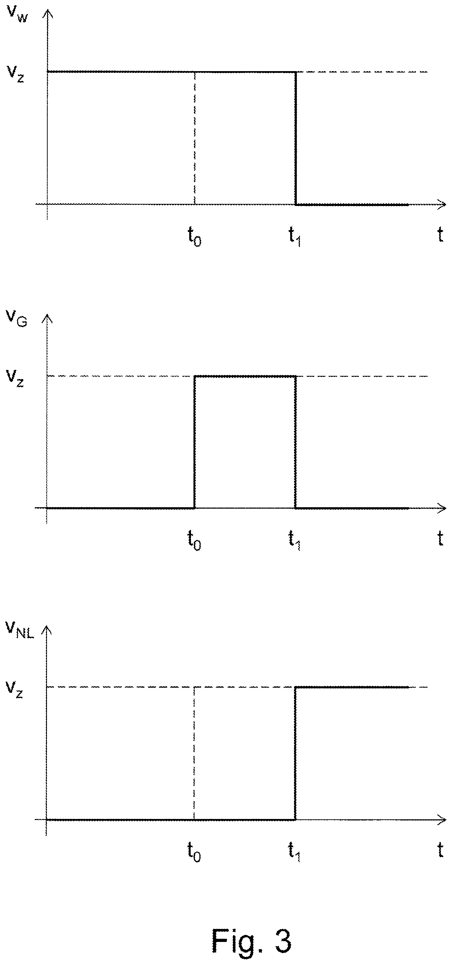

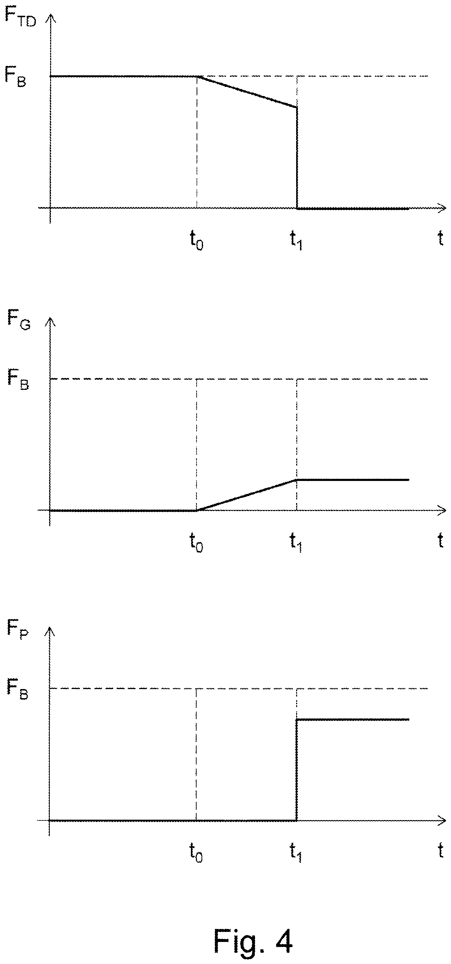

Die Funktionsweise des erfindungsgemäßen Betriebsverfahrens wird nachfolgend für einen ersten Verbindungsfall unter Bezugnahme auf die Fig. 1 und 2 anhand der Geschwindigkeit- und Kraft-Zeitverläufe in den Fig. 3 und 4 erläutert.

Ausgehend von der Konfiguration nach Fig. 1 wird der Ultraschallkopf 1 in die z-Richtung abgesenkt. Durch das Absenken wird in einem Mitnahmezeitpunkt $t_0$ zunächst ein Kontakt zwischen der Kontaktfläche 5 des Ultraschallwerkzeugs 4 und dem Anschlussleiter 6 ausgebildet. Der Anschlussleiter 6, der elastisch verformbar ist, wird vom Ultraschallwerkzeug 4 mitgenommen und senkt sich so in Richtung der Anschlussoberfläche 9 des Verbindungsbereichs 8 ab. Eine Berührung zwischen dem Anschlussleiter 6 und dem Verbindungsbereich 8 bildet sich dann erstmalig in einem Kontaktzeitpunkt $t_1$ aus.

Für den Verbindungsfall 1 sei angenommen, dass die aufgeprägte Bondkraft $F_B$ größer ist als eine zum Schließen des Spalts 10 aufzuprägende Schließkraft $F_G$. Dabei sei die Bondkraft $F_B$ konstant, wohingegen die Schließkraft $F_G$ linear mit einer Auslenkung $z_G$ des Anschlussleiters 6 aus der in Fig. 1 dargestellten Ruhelage zunehme. Die Schließkraft $F_G$ ist demzufolge zeitveränderlich. Sie wird durch die folgende Formel bestimmt:

$$F_G(t) = c_G \cdot z_G(t)$$

Hierbei kann $c_G$ als unbekannte Federkonstante des Anschlussleiters 6 aufgefasst werden.

Weiter sei angenommen, dass der Ultraschallkopf 1 langsam und mit konstanter Geschwindigkeit $v_z$ in die z-Richtung abgesenkt wird. Die Geschwindigkeit $v_z$ ist hierbei die zeitliche Ableitung z einer Verfahrposition z des Ultraschallkopfs 1 in die z-Richtung. Es wird also für die nachfolgende Erläuterung von einem quasistationären Prozess ausgegangen. Ebenso sei angenommen, dass die Komponenten des Ultraschallkopfes 1 einschließlich des Ultraschallwerkzeugs 4 sowie die Untergründe ideal starr sind. Dann können die Geschwindigkeitsänderungen im Mitnahmezeitpunkt $t_0$ und im Kontaktzeitpunkt $t_1$ als sprungförmig angesehen werden.

Wird der Ultraschallkopf 1 in die z-Richtung abgesenkt, verändert sich die Verfahrposition z des Ultraschallkopfes 1 mit der angenommen konstanten Geschwindigkeit $v_z = \dot{z}$. Da für den ersten Verbindungsfall angenommen ist, dass die Bondkraft $F_B$ größer ist als die Schließkraft $F_G$, entspricht eine Geschwindigkeit $v_W$ des Ultraschallwerkzeugs 4 in die z-Richtung der Geschwindigkeit $v_z$ des Ultraschallkopfes 1. Eine Relativbewegung zwischen dem Halter 2 und der Ultraschallerzeugungseinrichtung 3, an dem das Ultraschallwerkzeug 4 gehalten ist, ergibt sich bis zum Schließen des Spalts 10 nicht. Sobald der Spalt 10 zum Kontaktzeitpunkt $t_1$ geschlossen ist, bleibt das Ultraschallwerkzeug 4 stehen.

Betrachtet man alternativ die Verformung des Anschlussleiters 6, steht dieser bis zum Mitnahmezeitpunkt $t_0$ still. Seine Auslenkung $z_G$ ist wie die Verformungsgeschwindigkeit $v_G$ bis zum Mitnahmezeitpunkt $t_0$ null. Ab dem Mitnahmezeitpunkt $t_0$ wird der Spalt 10 mit einer Geschwindigkeit

$$v_G = \dot{z}_G = v_z$$

geschlossen. Im Kontaktzeitpunkt $t_1$ liegt der Anschlussleiter 6 an der Anschlussoberfläche 9 des Verbindungsbereichs 8 an. Seine Geschwindigkeit $v_G$ ist wie die Geschwindigkeit $v_W$ des Ultraschallwerkzeugs 4 ab diesem Zeitpunkt null.

Ab dem Kontaktzeitpunkt $t_1$ wird durch das weitere Absenken des Ultraschallkopfes 1 in die z-Richtung die Ultraschallerzeugungseinrichtung 3 sich vom Träger 2 lösen. Es kann insofern messtechnisch eine Relativposition $z_{NL}$ zwischen dem Träger 2 und der Ultraschallerzeugungseinrichtung 3 bestimmt werden. Die Geschwindigkeit $v_{NL} = \dot{z}_{NL}$, mit der sich die Ultraschallerzeugungseinrichtung 3 vom Träger 2 entfernt, entspricht der Geschwindigkeit $v_z$, mit der der Ultraschallkopf 1 in die z-Richtung abgesenkt wird. Eine Differenz $\Delta v$ ergibt sich demzufolge ab dem Kontaktzeitpunkt $t_1$ zu null. Es ist also mit dem erfindungsgemäßen Verfahren möglich, aus der Geschwindigkeitsdifferenz

$$\Delta v(t) = v_z(t) - v_{NL}(t)$$

den Kontaktzeitpunkt $t_1$ zu bestimmen. Die Ultraschallverbindungsvorrichtung sieht hierfür geeignete Messmittel, beispielsweise Wegsensoren vor.

Da die Federkonstante $c_G$ des Anschlussleiters 6 nicht bekannt ist, kann aus der Verfahrposition 6 des Ultraschallkopfes 1 im Kontaktzeitpunkt $t_1$ die Schließkraft $F_G$ nicht bestimmt werden. Stattdessen wird die Stützkraft $F_{TD}$ gemessen, mit der die Ultraschallerzeugungseinrichtung 3 gegen den Träger 2 angedrückt wird. Die Ultraschallerzeugungsvorrichtung kann hierzu geeignete Messmittel, beispielsweise Kraftsensoren, vorsehen. Die Prozesskraft $F_P$ nach dem Aufsetzen entspricht dann der Stützkraft $F_{TD}$ im Zeitpunkt $t_1$- unmittelbar vor dem Aufsetzen. Die dazugehörige Schließkraft $F_G$ zum Zeitpunkt $t_1$, die sich über

$$F_G(t_1) = F_B - F_{TD}(t_1-)$$

berechnen lässt, kann dann während der Herstellung der elektrisch leitenden, stoffschlüssigen Verbindung zwischen dem Anschlussleiter 6 und dem Verbindungsaufbau 7 berücksichtigt werden, denn für die Prozesskraft $F_P$ gilt

$$F_P = F_B - F_G(t_1).$$

Für den zweiten Verbindungsfall sei unterstellt, dass die Schließkraft $F_G$ größer ist als die Kraft, mit der der Ultraschallkopf 1 initial in die z-Richtung beaufschlagt wird. Die initial wirkende Kraft sei nachfolgend als Bondgrundkraftkomponente $F_{B0}$ verstanden.

Falls die Bondgrundkraftkomponente $F_{B0}$ kleiner ist als die Schließkraft $F_G$, die zum Schließen des Spalts 10 aufgebracht werden muss, löst die relativ beweglich zu dem Träger 2 an ebendiesem gehaltene Ultraschallerzeugungseinrichtung 3 sich von dem Träger 2, noch bevor der Spalt 10 vollständig geschlossen ist. Zusätzlich zu der Bondgrundkraftkomponente $F_{B0}$ wird dabei eine Bondwegkraftkomponente aufgeprägt, die zusammen mit der Bondgrundkraftkomponente $F_{B0}$ die in die z-Richtung wirkende Bondkraft $F_B$ definiert.

Es sei angenommen, dass die Bondwegkraftkomponente durch eine lineare Federkennlinie $c_B \cdot z_{NL}(t)$ beschrieben sei. $c_B$ definiert hier eine bekannte beziehungsweise experimentell bestimmbare Maschinenkonstante der Ultraschallverbindungsvorrichtung, die beispielsweise durch die Elastizität in der Aufhängung der Ultraschallerzeugungseinrichtung 3 am Träger 2 definiert ist.

Betrachtet man nunmehr die durch die Ultraschallverbindungsvorrichtung vorgegebene Bondkraft

$$F_B(t) = F_{B0} + c_B \cdot z_{NL}(t),$$

erhöht sich die Bondkraft $F_B$ im zweiten Verbindungsfall linear in Abhängigkeit von der Relativposition $z_{NL}$ zwischen Träger 2 und Ultraschallerzeugungseinrichtung 3, wobei sich bis zum Kontaktzeitpunkt $t_1$ der Spalt 10 stets sicher schließt.

Zu jedem Zeitpunkt während des Schließvorgangs gilt das Kräftegleichgewicht

$$F_G(t) = F_B(t)$$

beziehungsweise

$$c_G \cdot z_G(t) = F_{B0} + c_B \cdot z_{NL}(t)$$

und damit durch Ableitung die Geschwindigkeitsbeziehung während des Herunterdrückens des Anschlussleiter 6:

$$c_G \cdot v_G = c_B \cdot v_{NL}.$$

Die Summe der Geschwindigkeiten ergibt die Geschwindigkeit $v_z$, mit der der Ultraschallkopf 1 abgesenkt wird:

$$v_Z = v_G + v_{NL},$$

sodass sich die Geschwindigkeiten zu

$$v_W = c_B / (c_G + c_B) \cdot v_Z \text{ und}$$

$$v_{NL} = c_G / (c_G + c_B) \cdot v_Z$$

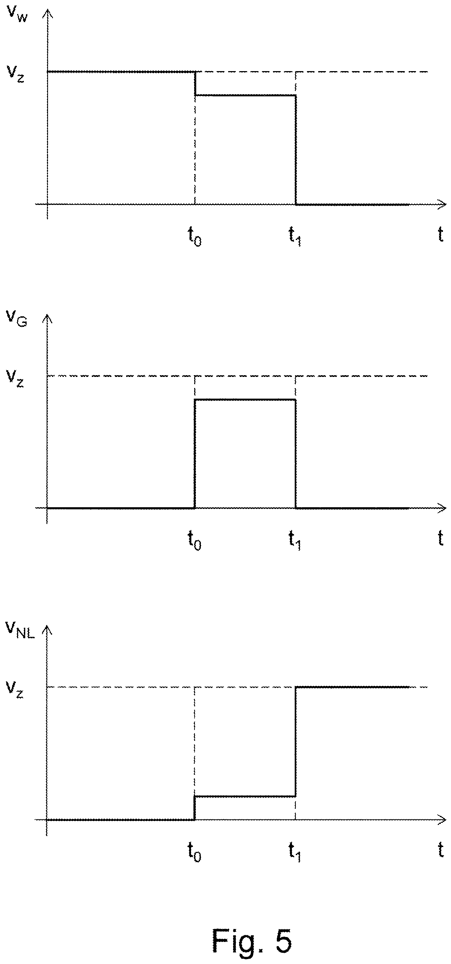

aufteilen. In Fig. 5 sind die Geschwindigkeitsverläufe mit der Aufteilung der Geschwindigkeit zwischen den Zeitpunkten $t_0$ und $t_1$ dargestellt. Vereinfachend sei hierbei angenommen worden, dass $F_{B0} = 0$ ist. Wesentlich ist dabei nicht der genaue, im vorliegenden Ausführungsbeispiel konstante Verlauf der Geschwindigkeiten $v_W$, $v_{NL}$ in der Schließphase. Vielmehr relevant ist die Tatsache, dass der Kontaktzeitpunkt $t_1$ erneut detektiert werden kann aufgrund der Differenz $\Delta v$ zwischen der zeitlichen Änderung der Verfahrposition z und der Relativposition $z_{NL}$, die sich zu null ergibt:

$$\Delta v(t) = v_Z(t) - v_{NL}(t) = \dot{z}(t) - z_{NL}(t) = 0$$

Zusätzlich kann die Schließkraft $F_G$ im Kontaktzeitpunkt $t_1$ ohne zusätzliche Kraftsensorik wie folgt bestimmt werden:

$$F_G = F_{B0} + c_B \cdot z_{NL}(t_1).$$

Die Prozesskraft $F_P$, die während der Herstellung der Ultraschallverbindung zwischen dem Anschlussleiter 6 und dem Verbindungsbauteil 7 wirkt, kann demzufolge aus der Differenz der Bondkraft $F_B$ und der Schließkraft $F_G$ im Kontaktzeitpunkt $t_1$ ermittelt werden:

$$F_P = F_B - F_G(t_1).$$

Im vorliegenden Ausführungsbeispiel des erfindungsgemäßen Betriebsverfahrens ist exemplarisch angenommen worden, dass die Ultraschallerzeugungseinrichtung 3 über elastische Verbindungselemente relativ beweglich zum Träger 2 an ebendiesem gehalten ist. Die infolge der Auslenkung (Relativposition $z_{NL}$) aufgeprägte Kraft ergab sich unter Berücksichtigung der Maschinenkonstanten $c_B$. Ebenso ist es möglich, dass die zwischen dem Träger 2 und der Ultraschallerzeugungseinrichtung 3 wirkende Kraft nicht linear von der Relativposition $z_{NL}$ abhängt und/oder zeit- beziehungsweise geschwindigkeitsabhängig bestimmt wird. Darüber hinaus kann die Befestigung der Ultraschallerzeugungseinrichtung 3 am Träger 2 über einen Aktuator erfolgen, sodass die Bondwegkraftkomponente variabel eingestellt beziehungsweise bestimmt werden kann.

Gleiche Bauteile und Bauteilfunktionen sind durch gleiche Bezugszeichen gekennzeichnet.

**Patentansprüche**

1. Verfahren zum Betreiben einer Ultraschallverbindungsvorrichtung, wobei die Ultraschallverbindungsvorrichtung einen in eine z-Richtung verfahrbaren Ultraschallkopf (1) vorsieht mit einem Träger (2), mit einer relativ beweglich zu dem Träger (2) an ebendiesem gehaltenen Ultraschallerzeugungseinrichtung (3) und mit einem von der Ultraschallerzeugungseinrichtung (3) zu Ultraschallschwingungen anregbaren Ultraschallwerkzeug (4), umfassend die folgenden Schritte:

   - ein elektrisch leitender Anschlussleiter (6) ist so oberhalb eines an einem Verbindungsbauteil (7) vorgesehenen, elektrisch leitend ausgebildeten Verbindungsbereichs (8) positioniert, dass zwischen dem Anschlussleiter und einer dem Anschlussleiter (6) zugewandten Anschlussoberfläche (9) des Verbindungsbereichs (8) ein Spalt (10) mit einem in die z-Richtung bestimmten Spaltmaß (s) gebildet ist,
   - der Ultraschallkopf (1) wird relativ zum Anschlussleiter (6) und dem Verbindungsbauteil (7) so positioniert, dass eine zur Anlage an dem Anschlussleiter (6) ausgebildete Kontaktfläche (5) des Ultraschallwerkzeugs (4) dem Anschlussleiter (6) zugewandt ist,
   - die Ultraschallerzeugungseinrichtung (3) wird mit einer in die z-Richtung wirkenden Bondkraft ($F_B$) beaufschlagt und gegen den Träger (2) angedrückt,

   dann werden

   - der Ultraschallkopf (1) in die z-Richtung abgesenkt und eine Verfahrposition (Z) des Ultraschallkopfes (1) in die z-Richtung sowie eine in die z-Richtung bestimmte Relativposition ($z_{NL}$) der Ultraschallerzeugungseinrichtung (3) zu dem Träger (2) ermittelt und
   - unter Berücksichtigung der Verfahrposition (z) und der Relativposition ($z_{NL}$) ein Kontaktzeitpunkt ($t_1$) ermittelt, an dem der Anschlussleiter (6) durch das Ultraschallwerkzeug (4) so weit abgesenkt ist, dass er den Verbindungsbereich (8) des Verbindungsbauteils (7) berührt.

2. Verfahren nach Anspruch 1, **dadurch gekennzeichnet, dass** der Kontaktzeitpunkt ($t_1$) bestimmt wird, indem eine Differenz ($\Delta v$) zwischen einer zeitlichen Änderung der Verfahrposition (z) und der Relativposition ($z_{NL}$) ermittelt und ein Nullwert für die Differenz ($\Delta v$) erkannt wird.

3. Verfahren nach Anspruch 1 oder 2, **dadurch gekennzeichnet, dass** die Bondkraft ($F_B$) sich als Funktion der Relativposition ($z_{NL}$) der Ultraschallerzeugungseinrichtung (3) zu dem Träger (2) bestimmt und eine von der Relativposition ($z_{NL}$) der Ultraschallerzeugungseinrichtung (3) zu dem Träger (2) abhängige Bondwegkraftkomponente umfasst.

4. Verfahren nach Anspruch 3, **dadurch gekennzeichnet, dass** die Bondkraft ($F_B$) sich additiv aus einer auf den Ultraschallkopf (1) aufgeprägten Bondgrundkraftkomponente ($F_{B0}$) und der Bondwegkraftkomponente ergibt.

5. Verfahren nach einem der Ansprüche 1 bis 4, **dadurch gekennzeichnet, dass** eine bekannte und bevorzugt lineare Abhängigkeit zwischen der Bondkraft ($F_B$) und/oder der Bondwegkraftkomponente einerseits und der Relativposition ($z_{NL}$) der Ultraschallerzeugungseinrichtung (3) zu dem Träger (2) andererseits gegeben ist.

6. Verfahren nach einem der Ansprüche 3 bis 5, **dadurch gekennzeichnet, dass** die Bondwegkraftkomponente durch einen Aktuator aufgeprägt wird und/oder einstellbar ist.

7. Verfahren nach einem der Ansprüche 1 bis 6, **dadurch gekennzeichnet, dass** für den Kontaktzeitpunkt ($t_1$) eine Stützkraft ($F_{TD}$) bestimmt wird, mit der die Ultraschallerzeugungseinrichtung (3) gegen den Träger (2) angedrückt wird.

8. Verfahren nach Anspruch 7, **dadurch gekennzeichnet, dass** die Stützkraft ($F_{TD}$) jedenfalls im Kontaktzeitpunkt ($t_1$) und bevorzugt kontinuierlich gemessen wird.

9. Verfahren nach einem der Ansprüche 1 bis 8, **dadurch gekennzeichnet, dass** für den Kontaktzeitpunkt ($t_1$) eine Schließkraft ($F_G$) bestimmt wird, die zum Schließen des Spalts (10) zwischen dem Anschlussleiter (6) und dem Verbindungsbauteil (7) aufgebracht wird.

10. Verfahren nach Anspruch 9, **dadurch gekennzeichnet, dass** die Schließkraft ($F_G$) als eine Summe der Bondgrundkraftkomponente ($F_{B0}$) und der Bondwegkraftkomponente im Kontaktzeitpunkt ($t_1$) bestimmt wird.

11. Verfahren nach einem der Ansprüche 7 bis 10, **dadurch gekennzeichnet, dass** aus der Bondkraft ($F_B$) einerseits und der für den Kontaktzeitpunkt ($t_1$) bestimmten Stützkraft ($F_{TD}$) und/oder Schließkraft ($F_G$) andererseits eine beim Herstellen der Ultraschallverbindung zwischen dem Anschlussleiter (6) und dem Verbindungsbauteil (7) wirkende Prozesskraft ($F_P$) bestimmt wird.

12. Verfahren nach Anspruch 11, **dadurch gekennzeichnet, dass** die Prozesskraft ($F_P$) ermittelt wird als Differenz der Bondkraft ($F_B$) und der Schließkraft ($F_G$).

13. Verfahren nach einem der Ansprüche 1 bis 12, **dadurch gekennzeichnet, dass** die Relativposition ($z_{NL}$) und/oder die Verfahrposition (z) messtechnisch erfasst werden.

14. Verfahren nach einem der Ansprüche 1 bis 13, **dadurch gekennzeichnet, dass** nach dem Kontaktzeitpunkt ($t_1$) die Ultraschallerzeugungseinrichtung (3) aktiviert wird und das Ultraschallwerkzeug (4) zu Ultraschallschwingungen anregt.

15. Verwendung eines Verfahrens nach einem der Ansprüche 1 bis 14 zum elektrisch leitenden Verbinden eines Laststromanschlussleiters (6) mit einem Verbindungsbereich (8) einer Leistungselektronik-Baugruppe als Verbindungsbauteil (7).

**Claims**

1. Method for operating an ultrasonic connecting device, wherein the ultrasonic connecting device provides an ultrasound head (1) displaceable in a z-direction, comprising a carrier (2), comprising an ultrasound generation device (3) movable relative to and held on the carrier (2), and comprising an ultrasonic tool (4) excitable in ultrasonic vibrations by the ultrasound generation device (3), comprising the following steps:

   - an electrically conductive joining conductor (6) is positioned above a connection region (8), which is provided on a connection component (7) and is formed electrically conductive, in such a way that a gap (10) having a gap dimension (s) determined in the z-direction is formed between the joining conductor and a joining surface (9) of the connection region (8) facing the joining conductor (6),
   - the ultrasound head (1) is positioned relative to the joining conductor (6) and connection component (7) in such a way that a contact face (5), formed for contact against the joining conductor (6), of the ultrasonic tool (4) is facing the joining conductor (6),
   - the ultrasound generation device (3) is subjected to a bonding force ($F_B$) acting in the z-direction and pressed against the carrier (2),

   and subsequently

   - the ultrasound head (1) is lowered in the z-direction, and a displacement position (Z) of the ultrasound head (1) in the z-direction and a relative position ($z_{NL}$), determined in the z-direction, of the ultrasound generation device (3) with respect to the carrier (2) are determined, and,
   - while taking account of the displacement position (z) and relative position ($z_{NL}$), a contact time ($t_1$) is determined at which the joining conductor (6) is lowered so far by the ultrasonic tool (4) as to touch the connection region (8) of the connection component (7).

2. Method according to claim 1, **characterised in that** the contact time ($t_1$) is determined by determining a difference ($\Delta v$) between a change over time in the displacement position (z) and in the relative position ($z_{NL}$) and detecting a zero value of the difference ($\Delta v$).

3. Method according to either claim 1 or claim 2, **characterised in that** the bonding force ($F_B$) is determined as a function of the relative position ($z_{NL}$) of the ultrasound generation device (3) with respect to the carrier (2) and comprises a bonding path force component dependent on the relative position ($z_{NL}$) of the ultrasound generation device (3) with respect to the carrier (2).

4. Method according to claim 3, **characterised in that** the bonding force ($F_B$) results additively from a base bonding force component ($F_{B0}$) exerted on the ultrasound head (1) and the bonding path force component.

5. Method according to any of claims 1 to 4, **characterised in that** there is a known and preferably linear dependency between the bonding force ($F_B$) and/or bonding path force component on the one hand and the relative position ($z_{NL}$) of the ultrasound generation device (3) with respect to the carrier (2) on the other hand.

6. Method according to any of claims 3 to 5, **characterised in that** the bonding path force component is exerted by an actuator and/or is adjustable.

7. Method according to any of claims 1 to 6, **characterised in that**, for the contact time ($t_1$), a support force ($F_{TD}$) is determined with which the ultrasound generation device (3) is pressed against the carrier (2).

8. Method according to claim 7, **characterised in that** the support force ($F_{TD}$) is measured at least at the contact time ($t_1$) and preferably continuously.

9. Method according to any of claims 1 to 8, **characterised in that**, for the contact time ($t_1$), a closing force ($F_G$) is determined which is applied between the joining conductor (6) and the connection component (7) to close the gap (10).

10. Method according to claim 9, **characterised in that** the closing force ($F_G$) is determined as a sum of the base bonding force component ($F_{B0}$) and the bonding path force component at the contact time ($t_1$).

11. Method according to any of claims 7 to 10, **characterised in that** a process force ($F_P$), acting between the joining conductor (6) and the connection component (7) when the ultrasound connection is being established, is determined from the bonding force ($F_B$) on the one hand and the support force ($F_{TD}$) and/or closing force ($F_G$) determined for the contact time ($t_1$) on the other hand.

12. Method according to claim 11, **characterised in that** the process force ($F_P$) is determined as the difference between the bonding force ($F_B$) and the closing force ($F_G$).

13. Method according to any of claims 1 to 12, **characterised in that** the relative position ($z_{NL}$) and/or displacement position ($z$) are detected by measuring.

14. Method according to any of claims 1 to 13, **characterised in that** after the contact time ($t_1$) the ultrasound generation device (3) is activated and the ultrasound tool (4) is excited in ultrasonic vibrations.

15. Use of a method according to any of claims 1 to 14 for electrically conductively connecting a load current joining conductor (6) to a connection region (8) of a power electronics assembly as a connection component (7).

**Revendications**

1. Procédé pour faire fonctionner un dispositif de liaison par ultrasons, dans lequel le dispositif de liaison par ultrasons prévoit une tête à ultrasons (1) pouvant être déplacée dans une direction z, avec un support (2), un dispositif générateur d'ultrasons (3) étant maintenu sur celui-ci et mobile de manière relative par rapport au support (2), et avec un outil à ultrasons (4) pouvant être excité en des vibrations ultrasonores par le dispositif générateur d'ultrasons (3), comprenant les étapes suivantes :

   - un conducteur de connexion électriquement conducteur (6) est positionné au-dessus d'une zone de liaison électriquement conductrice (8) prévue au niveau d'un composant de liaison (7), de telle sorte qu'un interstice (10) ayant une dimension d'interstice (s) déterminée dans la direction z est formé entre le conducteur de connexion et une surface de connexion (9) de la zone de liaison (8) dirigée vers le conducteur de connexion (6),
   - la tête à ultrasons (1) est positionnée par rapport au conducteur de connexion (6) et au composant de liaison (7) de telle sorte qu'une surface de contact (5) de l'outil à ultrasons (4) conçue pour s'appliquer contre le conducteur de connexion (6) est dirigée vers le conducteur de connexion (6),
   - le dispositif générateur d'ultrasons (3) est soumis à une force de liaison ($F_B$) agissant dans la direction z et est pressé contre le support (2),

   puis

   - la tête à ultrasons (1) est abaissée dans la direction z et une position de déplacement (z) de la tête à ultrasons (1) dans la direction z dans la direction z ainsi qu'une position relative ($z_{Nl}$) du dispositif générateur d'ultrasons (3) par rapport au support (2) est établie et,
   - en tenant compte de la position de déplacement (z) et de la position relative ($z_{NL}$), un instant de contact ($t_{1i}$) auquel le conducteur de connexion (6) est abaissé par l'outil à ultrasons (4) jusqu'à ce qu'il touche la zone de liaison (8) du composant de liaison (7), est déterminé.

2. Procédé selon la revendication 1, **caractérisé en ce que** l'instant de contact ($t_1$) est déterminé en établis-

sant une différence ($\Delta v$) entre une variation temporelle de la position de déplacement ($z$) et la position relative ($z_{NL}$) et en détectant une valeur nulle pour la différence ($\Delta v$).

3. Procédé selon la revendication 1 ou 2, **caractérisé en ce que** la force de liaison ($F_B$) est déterminée en fonction de la position relative ($z_{NL}$) du dispositif générateur d'ultrasons (3) par rapport au support (2) et comprend une composante de force de chemin de liaison dépendante de la position relative ($z_{NL}$) du dispositif générateur d'ultrasons (3) par rapport au support (2).

4. Procédé selon la revendication 3, **caractérisé en ce que** la force de liaison ($F_B$) est obtenue de manière additive à partir d'une composante de force de base de liaison ($F_{B0}$) appliquée sur la tête à ultrasons (1) et de la composante de force de chemin de liaison.

5. Procédé selon l'une des revendications 1 à 4, **caractérisé en ce qu'**il existe une dépendance connue, et de préférence linéaire, entre la force de liaison ($F_B$) et/ou la composante de chemin de liaison d'une part, et la position relative ($z_{NL}$) du dispositif de génération d'ultrasons (3) par rapport au support (2) d'autre part.

6. Procédé selon l'une des revendications 3 à 5, **caractérisé en ce que** la composante de force de chemin de liaison est marquée et/ou peut être réglée par un actionneur.

7. Procédé selon l'une des revendications 1 à 6, **caractérisé en ce qu'**une force d'appui ($F_{TD}$) est déterminée pour l'instant de contact ($t_1$), force avec laquelle le dispositif générateur d'ultrasons (3) est pressé contre le support (2).

8. Procédé selon la revendication 7, **caractérisé en ce que** la force d'appui ($F_{TD}$) est mesurée dans chaque cas à l'instant de contact ($t_1$), et de préférence en continu.

9. Procédé selon l'une des revendications 1 à 8, **caractérisé en ce qu'**une force de fermeture ($F_G$) est déterminée pour l'instant de contact ($t_1$), laquelle force est appliquée pour fermer l'interstice (10) entre le conducteur de connexion (6) et le composant de liaison (7).

10. Procédé selon la revendication 9, **caractérisé en ce que** la force de fermeture ($F_G$) est déterminée comme une somme de la composante de force de base de liaison ($F_{B0}$) et de la composante de force de chemin de liaison à l'instant de contact ($t_1$).

11. Procédé selon l'une des revendications 7 à 10, **ca-**

**ractérisé en ce qu'**à partir de la force de liaison ($F_B$) d'une part et de la force d'appui ($F_{TD}$) et/ou de la force fermeture ($F_G$) déterminée pour l'instant de contact ($t_1$) d'autre part, une force de processus ($F_P$) agissant lors de la réalisation du liaison par ultrasons entre le conducteur de connexion (6) et le composant de liaison (7) est déterminée.

12. Procédé selon la revendication 11, **caractérisé en ce que** la force de processus ($F_P$) est déterminée comme la différence entre la force de liaison ($F_B$) et la force de fermeture ($F_G$).

13. Procédé selon l'une des revendications 1 à 12, **caractérisé en ce que** la position relative ($z_{NL}$) et/ou la position de déplacement ($z$) sont détectées de façon métrologique.

14. Procédé selon l'une des revendications 1 à 13, **caractérisé en ce que** le dispositif générateur d'ultrasons (3) est activé après l'instant de contact ($t_1$) et excite l'outil à ultrasons (4) en des vibrations ultrasonores.

15. Utilisation d'un procédé selon l'une des revendications 1 à 14 pour relier de manière électriquement conductrice un conducteur de connexion de courant de charge (6) avec une zone de liaison (8) d'un ensemble électronique de puissance en tant que composant de liaison (7).

Fig. 1

Fig. 2

EP 4 284 587 B1

Fig. 3

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102019118249 A1
- US 4597519 A
- US 4571688 A